**Europäisches Patentamt**

**European Patent Office**

**Office européen des brevets**

(19)

(11) Publication number: **0 282 487 B1**

(12) # EUROPEAN PATENT SPECIFICATION

(45) Date of publication of patent specification:
**12.06.91 Bulletin 91/24**

(51) Int. Cl.⁵: **H05K 3/46**

(21) Application number: **86906988.0**

(22) Date of filing: **14.11.86**

(86) International application number:
**PCT/SE86/00524**

(87) International publication number:
**WO 87/03164 21.05.87 Gazette 87/11**

(54) **MEANS FOR USE IN MANUFACTURING CIRCUIT CARDS AND METHOD FOR MANUFACTURING THE MEANS.**

(30) Priority: **15.11.85 SE 8505425**

(43) Date of publication of application:
**21.09.88 Bulletin 88/38**

(45) Publication of the grant of the patent:
**12.06.91 Bulletin 91/24**

(84) Designated Contracting States:
**AT BE CH DE FR GB IT LI LU NL SE**

(56) References cited:
**DE-B- 2 838 982**
**GB-A- 2 030 781**

(56) References cited:
**GB-A- 2 078 448**
**C.F. Coombs, Printed Circuits Handbook, 2nd ed. 1979, Mc Graw Hill Book Company pp 24-8 - 25-44**

(73) Proprietor: **LEEB, Karl-Erik**
**Akerbärvägen 32**
**S-139 00 Varmdö (SE)**

(72) Inventor: **LEEB, Karl-Erik**
**Akerbärvägen 32**
**S-139 00 Varmdö (SE)**

(74) Representative: **Holmqvist, Lars J.H.**
**Lars Holmqvist Patentbyra AB Box 4289**
**S-203 14 Malmö 4 (SE)**

## Description

### TECHNICAL FIELD

The present invention relates to a means in a substrate and a conductive pattern applied thereon. Thus, the invention is directed to enabling greater flexibility in manufacturing and using circuit cards comprising such a substrate. The invention also relates to a method for manufacturing the substrate with associated conductive pattern.

### STATE OF THE ART

In the manufacturing circuit cards it is previously known to prepare a rigid circuit card using glass-fibre reinforced epoxy that forms a laminate. Rigid circuit cards may also comprise laminates of phenol and paper.

On these rigid circuit cards the printed conductive pattern is arranged in various layers which are mutually isolated and in predetermined locations interconnected via holes in the isolating layer. Such circuit cards may be provided with surface mounted components attached directly in the conductive pattern.

This type of card makes it possible to avoid wiring on one side of the card and supporting of components on the other side of the card. Hereby, making contact via through holes in the cards between the wiring and the components is avoided. However, the drawbacks are that you have to resort to the anchoring of the conductive pattern to the substrate.

In circuit cards it is also previously known to use flexible laminates, wherein the conductive pattern is disposed on one side and in one layer. The substrate may be provided with through holes utilized in bonding the components to the flexible substrate.

It is known to use flexible substrates in an intermediate step in manufacturing rigid circuit cards. By using this intermediate step very small components (chips) having many terminals in a very economical manner may be bonded to the finished circuit card.

### DISCLOSURE OF THE INVENTION TECHNICAL PROBLEM

In circuit cards there is a general interest of simplifying and making less expensive the manufacturing and handling the cards. A simplified manufacturing herein also refers to a greater degree of automatization in the manufacturing of the cards. A simplified handling involves inter alia that the freedom of choice in the manufacturing process can be increased, e.g. the parts concerning assembling and testing the components of the cards (the chips). Even the use of the card itself may be simplified inasmuch as that the mechanical arrangements for bonding the card may be made more advantegous.

There is additionally a great interest of providing circuit card structures enabling the use of a simple and effective cooling and dissipating function for the heat generated by the components.

### THE SOLUTION

It is an object of the present invention to solve inter alia the above-mentioned problems. To realize the object of the invention it is suggested as a first feature that the substrate should present a great flexibility. A second feature is that the conductive pattern is arranged in at least two layers isolated from each other and on one side of the substrate only. A third feature is that the substrate is provided with a form suitable for feeding at least in single steps in a continous process.

The above mentioned object is realised with means according to claim 1 and a method for manufacturing the means according to claim 8.

In this way a flexible substrate is achieved which is coated on one side with etched or plated conductive pattern, with an isolated layer placed over this conductive pattern, and one further conductive pattern applied to the isolating layer. Contact points are disposed through the isolating layer so that contact may be established between the two conductive pattern layers.

The substrate with conductive pattern applied in this manner constitutes a support for mounting the components in question. The substrate may be provided with a form making it suitable for keeping on or in a roll in an intermediate storing step, e.g. before mounting the components.

The radius of curvature of the substrate is 100 mm or less. Substrates having radiuses of curvature within the range 5 to 30 mm or about 10 mm are preferred.

Seen in the longitudinal direction of the substrate the pattern is repeated and the substrate may be pre-treated (cut, etc.) so that splitting of the substrate in separate complete units easily may be achieved.

The wiring may also form part of the circuit card, which wiring thus connects two or more component supporting portions on respective separate units. The latter may also be varied in that they present different forms, have different conductive patterns etc. E.g. a component supporting portion may be provided with a wiring portion serving as terminal means.

The substrate is provided with mechanical cuts e.g. in the side edges (cf. a film strip) disposed such that a precise feeding may be performed in the continuous process.

The method of the invention comprises as a first feature that a fibre material together with a curable plastic binder, e.g. epoxy resin is applied to a support with great flexibility. A further feature is that any gas bubbles appearing in manufacturing said support are removed and that the plastic binder is cured simultaneously or after removing the gas bubbles. In addition the method includes two further features comprising one step, wherein the substrate is treated, e.g. punched, cut by laser etc. and a second step, wherein the conductive pattern is applied in at least two layers on one side of the substrate, which layers are isolated from each other and possibly interconnected via predetermined contact points crossing the isolation. The latter two steps may be performed in the described order or in the reversed order.

In a preferred embodiment the web is formed by a woven or non-woven textile, preferably comprising glass fibre. The web is preferably impregnated by epoxy resin. The web thus impregnated is cured by letting it pass pressed between two surfaces of e.g. steel at the same time as the temperature is raised so that the binder is polymerized. The pressure between the surfaces is selected sufficiently high so that the gas bubbles are eliminated in the produced laminate. Preferable an apparatus is used which is disposed to enabling a process which may be performed with the web travelling from one roll to another roll.

After curing and elimination of gas bubbles hole making may be performed so that said holes for feeding are achieved and the positioning of the substrate in different stations in a continous process thereafter may be performed with the desired precision. Additionally, customized holes may be made e.g. for mounting modules and semi-conductor chips.

In a preferred embodiment the laminate thus achieved is cemented to a copper foil. Alternatively a thin metal layer may be vapourized or sprayed on the laminate and this latter may be reinforced by electroplating copper through a resist mask, whereupon the portions in question of the thin layer are etched off.

Crossings are constructed by screen-printing polymer dielectrics and utilizing conductors comprising a blend of metal or carbon powder and polymer binder, so-called polymer thick film.

Also the copper pattern and the polymer film printing is suitably arranged so that it may be performed from one roll to another.

## ADVANTAGES

The flexible substrate disclosed above may be delivered on a roll from which it in a simple manner may be automatically fed in a mounting and/or testing line.

The circuit cards thus manufactured may be utilized for many various specific functions and are inexpensive to mount and manufacture.

By the suggestion above many advantages are achieved and many problems are solved. The design as a strip together with holes facilitating a precise feeding in process steps provides advantages during manufacturing and the subsequent mounting and testing.

The thin laminate/substrate with the applied wiring may be applied (cemented) to any mechanical support which thereby may be formed so that cooling and dissipating the generated heat may effectively be arranged. The thermal resistance is directly depending on the thickness of the substrate and this being thin according to the invention the condition for good cooling is provided.

The application on any support provides great combination possibilities. However, the substrate may work itself without mechanical support. This gives advantages in applications in spaces that are narrow and difficult of access. The substrate with applied wiring and components may also be cemented directly on inner walls, casing insides, etc.

The substrate may also be arranged so that it is connected to mechanical supports at predetermined portions, e.g. to cooling plates, while other portions are freely suspended and in themselves form a flexible terminal link.

The object of the invention also gives advantages in that making contact via through-holes in the substrate is avoided, which provides the conditions for an economical manufacturing and avoiding big sources of error.

Cable function may also be built in into the substrate. In this connection, the substrate may be of a shape such that it for instance presents two different portions supporting components and interconnected with the conductive pattern on a part connecting said portions. The connecting part may be of great length. In addition, only one portion may be connected to the part.

## DESCRIPTION OF THE DRAWINGS

A presently suggested embodiment presenting the characterizing features of the invention will be described below with reference to the appended drawing wherein

Fig. 1 in principle shows a first manufacturing step of the substrate, and

Fig. 2 in vertical cross-section shows an example of the structure of the substrate.

## THE BEST EMBODIMENT

The substrate may comprise a support that in itself is significantly flexible. The support may be constituted of woven glass fabric, non-woven fiber material, glass flakes, reinforced plastic material, etc. The support is impregnated with curable plastic material, e.g. epoxy resin, applied on both sides. The epoxy resin is applied and cured so that a minimum of gas bubbles appear. An epoxy resin with great wettability, i.e. low surface tension and low viscosity, is used.

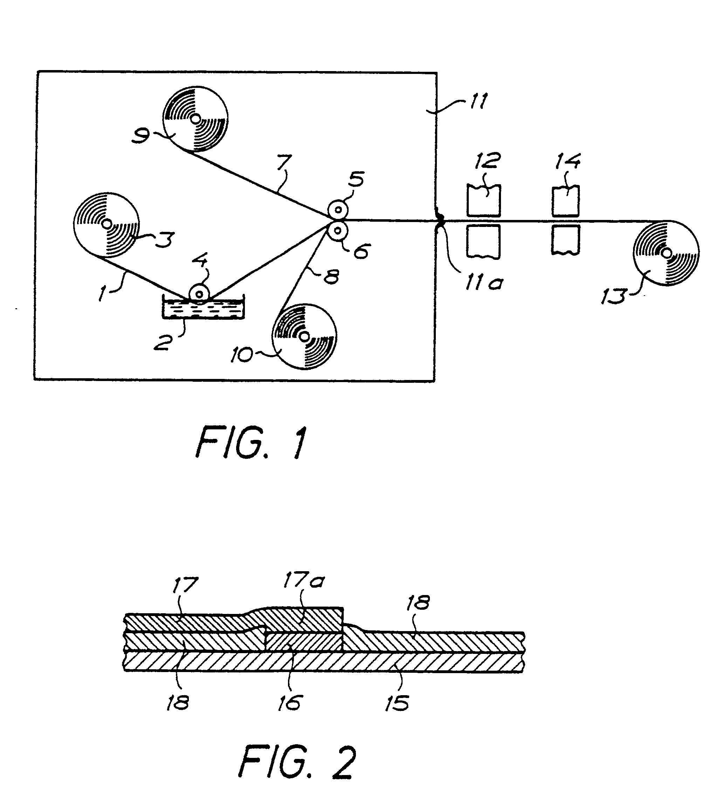

Fig. 1 shows an example of how a support in a continuous process passes a bath 2 with epoxy resin with a suitable hardener (e.g. an hydride hardener, aromatic amine hardeners, etc.). The support is fed from a cylinder 3 and guided by a roll 4 out of the bath towards the guide rolls 5 and 6. The latter rolls may also serve as press rolls and press gas bubbles (air bubbles) out of the web. In the example shown the web is fitted in protecting foils 7 and 8 fed from cylinders 9 and 10. An alternative to the bath 2 is that the epoxy resin is applied by spraying, by so called curtain coating, etc.

The described process is preferably performed in a room placed under a negative pressure, e.g a low pressure chamber 11, which may be of a type known per se. The negative pressure may be e.g. 50% or less of the atmospheric pressure. The impregnated web interposed between the foils 7 and 8 is fed out of the chamber via rubber lips 11a, sluices or the like, to a space surrounding the low pressure chamber which may be under atmospheric pressure. The higher pressure compresses any remaining gas/air bubbles so that these get a lesser share of the finished product in terms of volume. Outside the chamber the curing of the epoxy resin is initiated by curing initiating means 12. The latter means may consist of IR curing (infrared radiation). After curing the finished substrate is stored on a cylinder 13. This storing may constitute an intermediate storing before the substrate thus applied to a cylinder or the like is submitted the next process step.

Before feeding to the cylinder 13 the substrate may be submitted a mechanical treating in a station 14. This mechanical treating may in principle also be performed in a separate process step after storing on the cylinder 13. By the mechanical treatment feeding cuts (cf. those existing on rolls of film) are achieved, the desired outer shape of the substrate, splitting sections for an easy splitting of the substrate in complete separate units at the end of the manufacturing line, recesses for components, etc. The mechanical treating may be performed by punches, cutting with laser, water jets, etc.

The further steps of the process comprise the application of conductive layers in two layers on one side of the substrate. The substrate may be fed in direct continuation from the mechanical treatment station 14 or from intermediate storing on the cylinder 13 to a cement application station. The cement in question is applied on one side of the substrate. The cement may be applied by spraying, rolling, etc. Thereafter, the substrate is brought together with a conducting foil, e.g. a copper foil, that is adhered by said cement layer. The cement is cured in a manner known per se. The curing process may be initiated by heating, light radiation, pressure, etc.

Then the conducting foil is etched in a known manner using a resist, e.g. a photo resist, and etching.

In case copper conductors are to extend in recesses in the finished substrate (the circuit card) the resist is applied on both sides of the surface so that etching is prevented via the rear sides of the copper conductors at said recesses.

When a first conductive pattern is thus applied to the substrate an isolating layer is applied to the conductive pattern. Holes in the isolated layer are made in the locations where connection is to take place to an already applied conductive pattern. These holes may be achieved by screen printing a pattern for said holes (hole pattern). As an isolating layer, a light sensitive varnish may alternatively be used, which varnish is exposed to light in a manner known per se.

Thereafter, the second conductive pattern is applied. This is preferably done by screen printing on a blend of metal and plastic binder/polymere binder or carbon and polymere binder.

If more layers of conductive patterns are desired on the two layers of conductive pattern thus applied, this may be done in a manner corresponding to the manner described.

Thereby the flexible circuit card with associated conductive pattern is finished and may be intermediately stored in or on a depot (cylinder, reel, etc).

The flexible circuit card is used in direct continuation of the above or after said intermediate storing in a further production line for complete circuit cards. The latter production line comprises mounting components on the circuit card and testing components, which may be accomplished in a manner known per se. Finally, the pattern card is split for forming separate complete circuit cards.

The substrate/pattern card has great flexibility, compare for instance the flexibility of KAPTON foil. Great flexibility refers to such flexibility allowing a radius of curvature without functional failing of about 100 mm or less. Usually a small radius of curvature is desired, e.g. a radius of curvature falling within the range of 5-30 mm or being e.g. about 10 mm.

Fig. 2 shows an example of a finished substrate with associated wiring. In the figure the substrate is designated by 15, the lower conductive pattern by 16. An upper conductive pattern is designated by 17. The varnish layer separating the upper and the lower conductive patterns 16 and 17, respectively, is designated by 18. A binding function is symbolized by the binding part 17a extending through a cut in the isolating layer 18.

The invention is not limited to the above embodiment shown as an exampel but may undergo modifications within the scope of the subsequent claims.

## Claims

1. Means comprising a substrate (15) and conductive patterns (16, 17) applied thereon enabling an increased flexibility in manufacturing pattern cards, **characterized** in that the substrate presents a great flexibility, that the conductive pattern is disposed in at least two layers isolated from each other and on one side of the substrate only, that the substrate is reinforced and in that the first conductive pattern layer comprises a conducting foil and that the second layer comprises a screen printed blend of metal and plastic binder/polymere binder or carbon and polymere binder, and in that the substrate is provided with a form suitable for feeding in at least single steps in a continuous process.

2. Means according to claim 1, **characterized** in that the substrate may be applied to a mechanical support, for instance on a wall, a plate or other supporting unit of metal, plastics or other supporting material.

3. Means according to claim 1 or 2, **characterized** in that the substrate with applied conductive pattern is disposed for storing on a cylinder (13), reel or the like depot or for storing in independent rolls.

4. Means according to claim 1, 2 or 3, **characterized** in that the substrate and the conductive pattern applied thereon has an allowed radius of curvature of 100 mm or less, for instance a radius of curvature falling within the range 5-30 mm or being about 10 mm.

5. Means according to any one of the preceding claims, **characterized** in that the substrate comprises conductive patterns arranged after each other in the longitudinal direction of the substrate, which patterns are identical or vary in a predetermined way, and in that a substrate is mechanically treated or shaped for enabling a simple splitting of the substrate in separate units forming a complete unit, respectively.

6. Means according to any one of the preceding claims, **characterized** in that wiring connecting parts from one or between two or more components supporting parts are included in said conductive pattern and that said wiring connecting parts may be of great length, for instance up to several meters, whereby the necessity of contact means and between these conventionally structured wiring among components supporting parts are avoided.

7. Means according to any one of the preceding claims, **characterized** in that the substrate is provided with cuts, for instance at least in one side edge, disposed to enable a precise feeding in the continuous process.

8. Method for manufacturing the means according to claim 1, **characterized** by the following steps :

a) applying a fiber material, for instance glass fiber, together with a curable plastic binder, for instance epoxy resin, to a support, for instance a web (1) of a woven material, textile, plastic, etc., having a great flexibility ;

b) removing possibly existing gas bubbles and curing the plastic binder simultaneously or after the removal of the gas bubbles ;

c) mechanically treating the substrate thus achieved, for instance by punching, cutting with laser, cutting with a water jet, etc. ; and

d) applying a conducting foil on one side of the substrate for forming a constructive pattern on said side of the substrate, applying an isolating layer on the conducting foil and applying a blend of metal and plastic binder/polymere binder or carbon and polymere binder using screen printing on the isolating layer.

**Ansprüche**

1. Anordnung, umfassend ein Substrat (15) und auf dieses aufgebrachte Leitungsbilder (16, 17), welche eine erhöhte Flexibilität in der Herstellung gedruckter Schaltungen gestattet, dadurch **gekennzeichnet**, daß das Substrat eine große Flexibilität bietet, daß das Leitungsbild in mindestens zwei voneinander isolierten Lagen, und lediglich auf einer Seite des Substrats aufgebracht ist, daß das Substrat verstärkt ist, und dadurch, daß die erste Leitungsbild-Lage eine Leitungsfolie umfaßt und die zweite Lage eine siebbedruckte Mischung aus Metall und/oder Kunststoffbinder-Polymerbinder oder Karbon- und Polymerbinder umfaßt, und daß das Substrat in einer Form vorgesehen ist, die sich für einen Transport mindestens in Einzelschritten in einem kontinuierlichen Prozeß eignet.

2. Anordnung nach Anspruch 1, dadurch **gekennzeichnet**, daß das Substrat an einem mechanischen Träger angebracht werden kann, beispielsweise an einer Wand, einer Platte oder einer anderen Trägereinheit aus Metall, Kunststoffen oder anderen Trägermaterialien.

3. Anordnung nach Anspruch 1 oder 2, dadurch **gekennzeichnet**, daß das Substrat mit dem aufgebrachten Leitungsbild zur Lagerung auf einem Zylinder (13), einer Rolle od.dgl. speicherbar oder für eine Lagerung in voneinander unabhängigen Rollen vorgesehen ist.

4. Anordnung nach Anspruch 1, 2 oder 3, dadurch **gekennzeichnet**, daß das Substrat und das auf dieses aufgebrachte Leitungsbild einen zulässigen Krümmungsradius von 100 mm oder weniger besitzt, z.B. einen Krümmungsradius, der innerhalb eines Bereiches von 5 bis 30 mm liegt oder etwa 10 mm beträgt.

5. Anordnung nach einem der vorangehenden Ansprüche, dadurch **gekennzeichnet**, daß das Substrat Leitungsbilder aufweist, die nacheinander in Längsrichtung des Substrats angeordnet sind, wobei die Leitungsbilder identisch sind oder in einer vorbestimmten Weise variieren, und dadurch, daß ein Substrat mechanisch bearbeitet oder geformt wird, um ein einfaches Trennen des Substrats in einzelne Einheiten, die jeweils eine komplette Einheit bilden, zu ermöglichen.

6. Anordnung nach einem der vorangehenden Ansprüche, dadurch **gekennzeichnet**, daß in das Leitungsbild Verdrahtungsverbindungsteile von einem, oder zwischen zwei oder mehreren, Bauteile tragenden Teilen eingeschlossen sind und daß diese Verdrahtungs-Verbindungsteile großer Länge sein können, beispielsweise bis zu mehreren Metern, wobei das Erfordernis von Kontaktmitteln zwischen herkömmlich strukturierten Verdrahtungen und bauteiltragenden Teilen entfällt.

7. Anordnung nach einem der vorangehenden Ansprüche, dadurch **gekennzeichnet**, daß das Substrat mit Einschnitten versehen ist, z.B. zumindest in einem Seitenrand, die vorgesehen sind, um ein präzises Fördern in dem kontinuierlichen Prozeß zu ermöglichen.

8. Verfahren zur Herstellung einer Anordnung nach Anspruch 1, **gekennzeichnet** durch folgende Schritte :

a) Aufbringen eines Fasermaterials, z.B. Glasfaser, zusammen mit einem härtbaren Kunststoffbinder, beispielsweise Epoxyharz, auf eine Trägerschicht, z.B. ein Gewebe (1) aus gewobenem Material, Textil, Kunststoff etc. mit einer größeren Flexibilität,

b) Entfernen möglicherweise vorhandener Gasbläschen und Aushärten des Kunststoffbinders gleichzeitig mit oder nach dem Entfernen der Gasbläschen,

c) mechanisches Behandeln des Substrats, das auf diese Weise erhalten wird, z.B. durch Stanzen, Laserschneiden, Schneiden mit einem Wasserstrahl und

d) Aufbringen einer leitenden Folie auf eine Seite des Substrats für die Bildung eines Leitungsbildes auf dieser Seite des Substrats, Aufbringen einer Isolationsschicht auf die Leiterfolie und Aufbringen einer Mischung aus Metall- und Kunststoffbinder/Polymerbinderfolien und Polymerbinder unter Einsatz von Siebdruck auf die Isolationsschicht.

## Revendications

1. Dispositif comprenant un substrat (15) et des configurations conductrices (16, 17) appliquées sur celui-ci, procurant une plus grande souplesse dans la fabrication de cartes à circuits, caractérisé en ce que le substrat présente une grande flexibilité, la configuration conductrice est disposée en au moins deux couches isolées l'une de l'autre et sur une seule face du substrat, le substrat est renforcé, la première couche de configuration conductrice comprend un film conducteur et la deuxième couche comprend un mélange, imprimé à l'écran, de métal et de liant plastique/liant de type polymère, ou de carbone et de liant de type polymère, et le substrat comporte des éléments permettant une avance au moins par pas uniques dans un traitement continu.

2. Dispositif suivant la revendication 1, caractérisé en ce que le substrat peut être appliqué à un support mécanique, par exemple à une paroi, une plaque ou un autre élément support en métal, matière plastique ou autre matière support.

3. Dispositif suivant la revendication 1 ou 2, caractérisé en ce que le substrat portant la configuration conductrice appliquée est disposé pour stockage sur un cylindre (13), une bobine ou un récepteur analogue, ou pour stockage en rouleaux indépendants.

4. Dispositif suivant la revendication 1, 2 ou 3, caractérisé en ce que le substrat et la configuration conductrice appliquée sur celui-ci ont un rayon de courbure possible de 100 mm ou moins, par exemple un rayon de courbure compris entre 5 et 30 mm ou de 10 mm environ.

5. Dispositif suivant l'une quelconque des revendications précédentes, caractérisé en ce que le substrat comprend des configurations conductrices placées les unes à la suite des autres dans la direction longitudinale du substrat, ces configurations étant identiques ou variant d'une façon prédéterminée, et un substrat est mécaniquement traité ou formé pour permettre une division simple du substrat en unités séparées constituant respectivement une unité complète.

6. Dispositif suivant l'une quelconque des revendications précédentes, caractérisé en ce que des parties de câblage de connexion, à partir d'une région de montage de composant ou entre deux ou plus régions de montage de composant, sont incorporées dans ladite configuration conductrice, et lesdites parties de câblage de connexion peuvent être de grande longueur, par exemple jusqu'à plusieurs mètres, de sorte qu'on évite la nécessité de moyens de contact et, entre ceux-ci, d'un câblage de structure usuelle entre les régions de montage de composant.

7. Dispositif suivant l'une quelconque des revendications précédentes, caractérisé en ce que le substrat comporte des découpes, par exemple au moins dans un bord latéral, disposées pour permettre une avance précise dans le traitement continu.

8. Procédé pour la fabrication du dispositif suivant la revendication 1, caractérisé par les étapes suivantes :

(a) application d'une matière fibreuse, par exemple des fibres de verre, ainsi que d'un liant en matière plastique durcissable, par exemple une résine époxy, à un support, par exemple une bande (1) d'une matière tissée, d'un textile, d'une matière plastique, etc., ayant une grande flexibilité ;

(b) élimination des bulles de gaz éventuellement existantes et durcissement du liant plastique simultanément ou postérieurement à l'élimination des bulles de gaz ;

(c) traitement mécanique du substrat ainsi obtenu, par exemple par poinçonnement, découpe au laser, découpe au jet d'eau, etc. ; et

(d) application d'un film conducteur sur une face du substrat pour former une configuration conductrice sur ladite face du substrat, application d'une couche isolante sur le film conducteur et application d'un mélange de métal et de liant plastique/liant de type polymère, ou de carbone et de liant de type polymère, par impression à l'écran sur la couche isolante.

FIG. 1

FIG. 2